# EUROPÄISCHE PATENTSCHRIFT

(11) **EP 2 316 161 B1**
(45) Veröffentlichungstag und Bekanntmachung des Hinweises auf die Patenterteilung: **09.07.2014**
(21) Anmeldenummer: 09777926.8
(22) Anmeldetag: 17.08.2009
(51) Int. Cl.: H01L 41/113, H02N 2/18, H02P 9/00, H02P 25/02

(54) **VERFAHREN UND VORRICHTUNG ZUM ERZEUGEN VON ELEKTRISCHER ENERGIE AUS EINER MECHANISCHEN ANREGUNGSSCHWINGUNG**
METHOD AND DEVICE FOR GENERATING ELECTRIC ENERGY FROM MECHANICAL EXCITATION OSCILLATION
PROCÉDÉ ET DISPOSITIF POUR PRODUIRE DE L'ÉNERGIE ÉLECTRIQUE À PARTIR D'UNE VIBRATION D'EXCITATION MÉCANIQUE

(30) Priorität: 18.08.2008 DE 102008038293
(43) Veröffentlichungstag der Anmeldung: 04.05.2011
(73) Patentinhaber: Albert-Ludwigs-Universität Freiburg, 79098 Freiburg (DE); Hahn-Schickard-Gesellschaft für angewandte Forschung e.V., 78052 Villingen-Schwenningen (DE)
(72) Erfinder: SCHOCK, Wolfram, 72768 Rommelsbach (DE); PETERS, Christian, 79100 Freiburg (DE); MAURATH, Dominic, 79100 Freiburg (DE); MANOLI, Yiannos, 79104 Freiburg (DE); SPREEMANN, Dirk, 79244 Münstertal (DE)
(74) Vertreter: Huwer, Andreas
(86) Internationale Anmeldenummer: PCT/EP2009/005955
(87) Internationale Veröffentlichungsnummer: WO 2010/020389

(56) Entgegenhaltungen:
- GB-A- 2 425 160
- US-A- 5 578 877

## Beschreibung

Die Erfindung betrifft eine Vorrichtung zum Erzeugen von elektrischer Energie aus einer mechanischen Anregungsschwingung, mit einem mechanischen Resonator, der mindestens ein Resonanzelement und eine Halterung dafür aufweist, auf welche die Anregungsschwingungen übertragbar sind, wobei das Resonanzelement an einer Befestigungsstelle mit der Halterung verbunden ist und an einer von der Befestigungsstelle beabstandeten Auslenkstelle relativ zu der Befestigungsstelle elastisch auslenkbar ist, mit einem Stellglied zum Einstellen der Resonanzfrequenz des Resonanzelements, wobei die Auslenkstelle mit einem elektrischen Generator in Antriebsverbindung steht. Ferner betrifft die Erfindung ein Verfahren zum Erzeugen von elektrischer Energie aus einer mechanischen Anregungsschwingung, wobei ein mechanischer Resonator bereitgestellt wird, der mindestens ein an einer Halterung angeordnetes Resonanzelement aufweist, das an einer Befestigungsstelle mit der Halterung verbunden ist und an einer von der Befestigungsstelle beabstandeten Auslenkstelle relativ zu der Befestigungsstelle elastisch auslenkbar ist, wobei die Halterung derart der Anregungsschwingung ausgesetzt wird, dass die Auslenkstelle relativ zu der Befestigungsstelle in Schwingungen versetzt wird.

Eine derartige Vorrichtung, die als Resonanzelement ein Feder-Massesystem aufweist, ist aus GB 2 425 160 A bekannt. Das eine Ende der Feder ist an einer Halterung eingespannt und das andere Ende ist mit einer relativ zu der Halterung auslenkbaren Inertialmasse verbunden. Die Resonanzfrequenz des Feder-Massesystem ist mittels eines Stellglieds einstellbar. Das Stellglied weist ein Piezoelement auf, das derart mit der Feder verbunden ist, dass durch Anlegen einer elektrischen Spannung an die Elektroden des Piezoelements die Federkonstante der Feder verstellbar ist. Die Halterung ist einer Anregungsschwingung ausgesetzt, die über die Halterung auf das Feder-Massesystem einwirkt und den die Inertialmasse relativ zu der Halterung auslenkt. Der Resonator ist zur Erzeugung von elektrischer Energie mit einem elektrischen Generator gekoppelt. Zur Messung der vom Generator abgegebenen elektrischen Leistung ist am Generator ein Leistungsmesser angeschlossen. Dieser ist mit einer Ansteuereinrichtung für das Stellglied verbunden. Mit Hilfe der Ansteuereinrichtung wird die Resonanzfrequenz des Feder-Massesystem solange verstellt, bis die gemessene Ausgangsleistung ein Maximum aufweist

Diese Vorgehensweise hat jedoch folgende wesentliche Nachteile:
1. Während der Suche nach der Resonanzfrequenz maximaler Ausgangsleistung wird von einer konstanten Anregungsamplitude ausgegangen. Verringert sich die Anregungsamplitude während dieses Suchvorgangs, wird fätschlicherweise ein Maximum der Ausgangsleistung detektiert. Die Energiegewinnung erfolgt dann mit reduziertem Wirkungsgrad.
2. Hat die Resonanzfrequenz die Anregungsfrequenz erreicht und bleibt konstant, muss weiterhin zyklisch nach dem Maximum der Ausgangsleistung gesucht werden. Während dieser Suche muss ständig die Stelleinrichtung betätigt werden, wodurch Energie verloren geht.
3. Ist das Maximum der Ausgangsleistung gefunden und wird die Suche erneut gestartet, ist unklar, ob die Suche in Richtung höherer oder niedrigerer Resonanzfrequenzen starten soll. Die Suche wird in etwa 50% der Fälle in die falsche Richtung begonnen, was unnötig Energie kostet.

Es besteht deshalb die Aufgabe, ein Verfahren und eine Vorrichtung der eingangs genannten Art zu schaffen, die es ermöglichen, aus einer mechanischen Anregungsschwingung mit hohem Wirkungsgrad elektrische Energie zu erzeugen.

Diese Aufgabe wird bezüglich der Vorrichtung dadurch gelöst, dass die Vorrichtung eine Messeinrichtung zum Erzeugen eines Phasendifferenzsignals für die Differenz zwischen der Phasenlage der Schwingung der Halterung und der Phasenlage der Schwingung der Auslenkstelle aufweist, und dass ein Ausgang der Messeinrichtung zum Anpassen der Resonanzfrequenz des Resonanzelements an die Frequenz der mechanischen Schwingung der Halterung über einen Phasenregler mit dem Stellglied verbunden ist.

Bezüglich des Verfahrens wird die vorstehend genannte Aufgabe dadurch gelöst, dass ein Phasendifferenzsignal für die Differenz zwischen der Phasenlage der Anregungsschwingung und der Phasenlage der Schwingung der Auslenkstelle erzeugt wird, dass das Phasendifferenzsignal mit einem Sollwertsignal verglichen wird, und dass beim Auftreten einer Abweichung zwischen dem Phasendifferenz-signal und dem Sollwertsignal die Resonanzfrequenz des Resonanzelements im Sinne einer Reduzierung der Abweichung verstellt wird.

Die Erfindung geht von dem Grundgedanken aus, dass bei einer vorbestimmten Phasendifferenz zwischen der Phasenlage der Anregungsschwingung und der Phasenlage der Schwingung der Auslenkstelle relativ zur Halterung die erzeugte elektrische Ausgangsleistung ein Maximum erreicht. In vorteilhafter Weise ist es durch die Messung der Phasendifferenz möglich, auf einfache Weise zu detektieren, ob die Resonanzfrequenz des mechanischen Resonators mit der Anregungsfrequenz übereinstimmt und in welche Richtung die Resonanzfrequenz gegebenenfalls verändert werden muss, um die Übereinstimmung zu erreichen.

Bei einer bevorzugten Ausgestaltung der Erfindung weist die Messeinrichtung einen ersten Sensor zur Erfassung eines von der mechanischen Anregungsschwingung abhängigen ersten Messsignals und einen zweiten Sensor zur Erfassung einer von der Auslenkung des Resonanzelements abhängigen zweiten Messsignals auf, wobei Messsignalausgänge der Sensoren über eine Phasenvergleichseinrichtung mit dem Ausgang der Messeinrichtung verbunden sind. Dabei können die Sensoren insbesondere zur Messung eines Messsignals ausgebildet sein, dass einer durch die Schwingung verursachten Auslenkung (Wegmessung) und/oder einer zeitlichen Ablenkung (Ceschwindigkeit, Beschleunigung) und/oder eines Zeitintegrals der Auslenkung entspricht. So kann beispielsweise die Geschwindigkeit, mit der sich die der Anregungsschwingung ausgesetzte Halterung bewegt, mit Hilfe eines kapazitiven Sensors gemessen werden, der mit einer ersten Elektrode mit einer ortsfesten Widerlagerstelle und mit einer zweiten Elektrode mit der Halterung verbunden ist.

Vorteilhaft ist, wenn der Phasenregler derart ausgestaltet ist, dass die Differenz zwischen der Phasenlage der Schwingung der Halterung und der Phasenlage der Schwingung des Resonanzelements auf -90° geregelt wird. Die mechanischen Schwingungen können dann mit einem besonders hohen Wirkungsgrad in elektrische Energie konvertiert werden.

Vorteilhaft ist, wenn der Phasenregler einen P-, PI-, PD- oder PID-Regler aufweist. Dabei wird ein PID-Regler bevorzugt, weil dadurch eine Drift der Phasendifferenz vermieden werden kann.

Bei einer zweckmäßigen Ausführungsform der Erfindung weist das Stellglied mindestens ein Piezoelement und eine elektrische Ansteuereinrichtung auf, die mit Elektroden des mindestens einen Piezoelements verbunden ist, wobei das Resonanzelement als Biegekörper ausgestaltet ist, und wobei das mindestens eine Piezoelement derart mit dem Biegekörper verbunden ist, dass es diesen bei Anlegen einer elektrischen Spannung an die Elektroden des Piezoelements versteift. Die Federkonstante des Biegekörpers kann dann durch Anlegen einer elektrischen Spannung an die Elektroden des Piezoelements auf einfache Weise und weitgehend verlustfrei entsprechend der einzustellenden Resonanzfrequenz verändert werden.

Vorteilhaft ist, wenn der zweite Sensor oder der Generator durch die Elektroden des mindestens einen Piezoelements und eine mit den Elektroden verbundene Hochpassschaltung gebildet ist. Das Piezoelement erfüllt dann eine Doppelfunktion, bei der es sowohl als Stellglied bzw. Aktor als auch als Sensor oder Generator dient. Dies ist dadurch möglich, dass der Frequenzbereich eines für die Phasenregelung benötigten Stellsignals für das Piezoelement wesentlich kleiner ist als Resonanzfrequenz des Resonators. Somit kann das Stellsignal vorzugsweise über einen Tiefpass mit niedrigen Frequenz an die Elektroden des Piezoelements angelegt werden, während die durch die Resonatorschwingung verursachten Signalanteile mit Hilfe eines Hochpasses aus dem an den Elektroden anliegenden Signal ausgekoppelt werden können..

Der Biegekörper ist bevorzugt als Federbalken ausgestaltet. Dadurch wird ein einfacher Aufbau des Resonators ermöglicht.

Bei einer bevorzugten Ausführungsform der Erfindung weist das Stellglied mindestens einen Aktor auf, der wenigstens zwei relativ zueinander verstellbare Aktorstellen hat, die derart mit dem Biegekörper verbunden sind, dass dieser durch Betätigen des Aktors um eine Biegeachse elastisch biegbar ist, wobei der Biegekörper mindestens zwei Biegekörperabschnitte hat, die mittels einer Schwenklagerung um eine zwischen der Befestigungsstelle und der Auslenkstelle angeordnete Schwenkachse relativ zueinander verschwenkbar miteinander verbunden sind, und wobei die Schwenkachse derart quer zur Biegeachse angeordnet ist, dass die Schwenklagerung durch Verschwenken der Biegekörperabschnitte relativ zueinander mit von der Biegeverformung abhängigen Zug- und/oder Druckkräften beaufschlagbar ist. Durch die Anregungsschwingung werden die Biegekörperabschnitte dazu angeregt, um die Schwenkachse relativ zueinander zu verschwenken. Durch Verstellen des mindestens einen Aktors kann die Geometrie wenigstens eines der Biegekörperabschnitte derart verändert werden, dass der elastische Werkstoff des Biegkörpers beim Verschwenken der Biegekörperabschnitte relativ zueinander verspannt wird und ein Rückstellmoment aufbringt, das der Schwenkbewegung entgegenwirkt. Dabei ist das Rückstellmoment von der Einstellung des Aktors bzw. vom Abstand der verstellbaren Aktorstellen abhängig. Somit lässt sich der Quotient zwischen Rückstellkraft und Schwenkwinkel, also die Federkonstante des Biegekörpers in einem weiten Bereich einstellen. Die Resonanzfrequenz des Resonators kann dadurch noch besser derart an die Anregungsfrequenz angepasst werden, dass die elektrische Ausgangsleistung des Generators ein Maximum aufweist.

Vorteilhaft ist, wenn die Biegekörperabschnitte als flächige, vorzugsweise plattenförmige Elemente ausgestaltet sind, und wenn die Schwenkachse im Wesentlichen in einer von mindestens einem der plattenförmigen Elementen aufgespannten Ebene oder parallel dazu angeordnet ist. Die Federkonstante, die der Biegekörper bezüglich der Schwenkachse aufweist, kann dann in einem noch größeren Bereich verstellt werden.

Zweckmäßigerweise ist die Schwenklagerung als Festkörpergelenk ausgestaltet, das mindestens zwei um die Schwenkachse relativ zueinander verschwenkbare Lagerteile aufweist, die einstückig miteinander verbunden sind. Dabei kann das Festkörpergelenk beispielsweise im Bereich der Schwenkachse eine kleinere Wandstärke aufweisen als die Wandstärke der Biegekörperabschnitte und/oder das Festkörpergelenk kann aus einem biegeweicheren Werkstoff bestehen als das die Biegekörperabschnitte. Gegebenenfalls ist es sogar möglich, dass das Festkörpergelenk einstückig mit den durch dieses miteinander verbundenen Biegekörperabschnitten ausgestaltet ist.

Bei einer bevorzugten Ausgestaltung der Erfindung weist die Schwenklagerung mindestens drei auf der Schwenkachse oder benachbart dazu angeordnete Gelenke auf, die in Richtung der Schwenkachse voneinander beabstandet sind. Die zwischen den Gelenken befindlichen Teilbereiche der Biegekörperabschnitte können sich dann leichter verformen, so dass sich die Federkonstante, die der Biegekörper bezüglich der Schwenkachse aufweist, entsprechend reduziert.

Vorteilhaft ist, wenn ein erstes Gelenk etwa mittig zwischen einem zweiten Gelenk und einem dritten Gelenk angeordnet ist, und wenn die Befestigungsstelle vorzugsweise in Höhe des ersten Gelenks angeordnet ist. Dadurch wird sich eine weitgehend symmetrische Ausgestaltung des Biegekörpers ermöglicht.

Bei einer vorteilhaften Ausführungsform der Erfindung weisen die einzelnen Gelenke jeweils zwei um eine Gelenkstelle relativ zueinander verschwenkbare Gelenkteile auf, von denen ein erstes Gelenkteil mit einem ersten Biegekörperabschnitt und ein zweites Gelenkteil mit einem zweiten Biegekörperabschnitt verbunden ist, wobei in einer Ruhelage, in welcher das Stellglied keine Biegekraft in den Biegekörper einleitet, die Gelenkstelle eines ersten Gelenks von einer die Gelenkstelle eines zweiten Gelenks mit der Getenkstelle eines dritten Gelenks verbindenden geraden Linie beabstandet ist. Die Biegekörperabschnitte sind also in der Ruhelage vorgespannt. Dadurch kann ein eventuell vorhandenes Lagerspiel kompensiert werden.

Nachfolgend sind Ausführungsbeispiele der Erfindung anhand der Zeichnung näher erläutert. Es zeigt
- Fig. 1: eine schematische Darstellung einer Vorrichtung zum Erzeugen von elektrischer Energie aus einer mechanischen Anregungsschwingung,
- Fig. 2: ein Blockschaltbild der Vorrichtung,
- Fig. 3: ein erstes Ausführungsbeispiel eines Resonators, der einen Biegekörper mit zwei relativ zueinander verschwenkbaren, flächigen Biegekörperabschnitten aufweist, wobei die Biegekörperabschnitte in einer gemeinsamen Ebene angeordnet sind,
- Fig. 4: eine Teilansicht des Resonators, die einen an einer Halterung eingespannten Biegekörperabschnitt zeigt, der sich in Ruhelage in einer Ebene erstreckt,
- Fig. 5: eine Darstellung ähnlich Fig. 4, wobei jedoch der Biegekörperabschnitt derart verformt ist, dass er einen von der Ebene abweichenden Verlauf aufweist, und
- Fig. 6: ein zweites Ausführungsbeispiel eines Resonators, bei dem die Schwenklagerung drei Lagerteile hat, deren Schwenkachsen nicht auf einer geraden Linie liegen, wenn die Biegekörperabschnitte in einer gemeinsamen Ebene angeordnet sind.

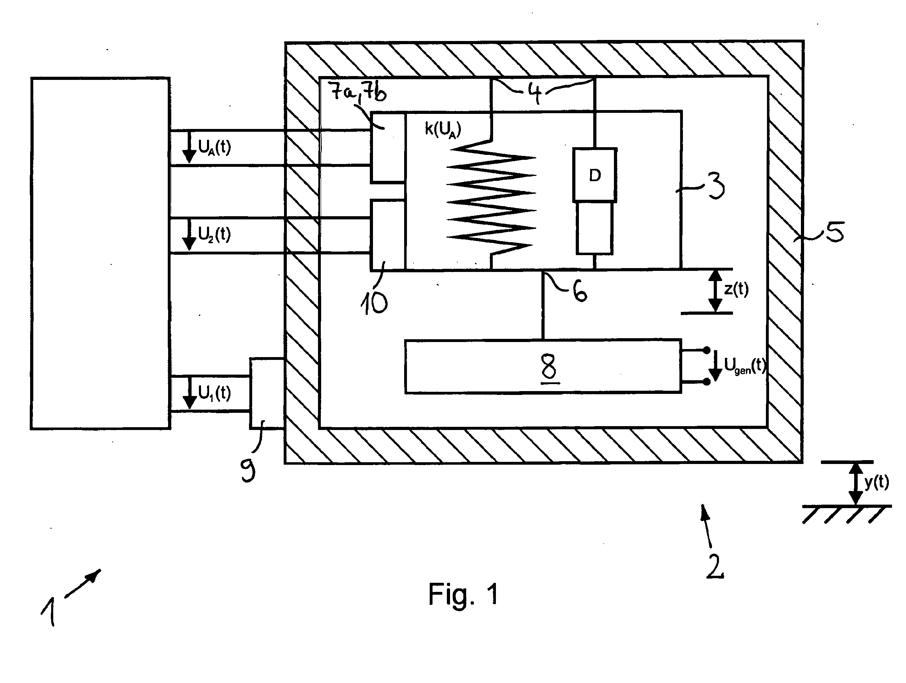

Eine in Fig. 1 im Ganzen mit 1 bezeichnete Vorrichtung zum Erzeugen von elektrischer Energie aus einer mechanischen Anregungsschwingung y(t) weist einen mechanischen Resonator 2 auf, der als Resonanzelement einen Biegekörper 3 hat, der aus einem biegeelastischen Werkstoff besteht. Der Biegekörper 3 bildet ein mechanisch gedämpftes Feder-Massesystem, was in Fig. 1 durch ein Federsymbol und ein parallel dazu angeordnetes Dämpfersymbol angedeutet ist. Die Federkonstante des Resonanzelements ist in Fig. 1 mit k(U_{A}) und die Dämpfung mit D bezeichnet. Die Anregungsschwingung y(t) wird gegen eine ortsfeste Referenzposition gemessen.

Der Biegekörper 3 ist an einer Befestigungsstelle 4 an einer Halterung 5 eingespannt, die derart mit einer in der Zeichnung nicht näher dargestellten mechanischen Anregungsquelle gekoppelt ist, dass eine von der Anregungsquelle erzeugte Anregungsschwingung y(t) auf die Halterung 5 übertragen wird. Die Anregungsquelle kann beispielsweise eine Hubkolbenverbrennungsmaschine sein.

An einer von der Befestigungsstelle 4 beabstandeten Auslenkstelle 6 ist der Biegekörper 3 entgegen der Rückstellkraft seines Werkstoffs aus einer Ruhelage relativ zu der Befestigungsstelle 4 elastisch auslenkbar. Die Auslenkung der Auslenkstelle 6 ist in Fig. 1 mit z(t) bezeichnet, wobei t die Zeit bedeutet. Die Auslenkung z(t) wird durch die Anregungsschwingung y(t) angeregt.

Zum Einstellen der Federkonstante k(U_{A}) des Biegekörpers 3 weist die Vorrichtung 1 ein Stellglied auf, das zwei in der Zeichnung nur schematisch dargestellte Piezoelemente 7a, 7b umfasst, deren Elektroden jeweils mit Ausgangsanschlüssen einer elektrischen Ansteuereinrichtung verbunden sind. Mit Hilfe der Ansteuereinrichtung kann eine elektrische Spannung U_{A} an die Elektroden der Piezoelemente 7a, 7b angelegt werden. Die Piezoelemente 7a, 7b sind derart mit dem Biegekörper 3 verbunden, dass sich dieser beim Anlegen der Spannung U_{A} an die Elektroden biegeverformt und versteift.

In Fig. 1 ist erkennbar, dass die Auslenkstelle 6 des Biegekörpers 3 mit einem an der Halterung 5 angeordneten elektrischen Generator 8 in Antriebsverbindung steht. Der Generator kann ein weiteres Piezoelement aufweisen, das eine Piezokeramik hat, auf die Elektroden aufgebracht sind. Das Piezoelement ist dabei derart angeordnet, dass sich unter dem Einfluss der Auslenkung z(t) die Piezokeramik verformt, so dass an den Elektroden eine piezoelektrische Spannung abgreitbar ist.

Der Generator kann aber auch eine,Spule aufweisen, die sich beim Auftreten einer Auslenkung z(t) derart in einem permanentmagnetischen Magnetfeld bewegt, dass in der Spule eine elektrische Spannung induziert wird.

Ferner kann der Generator auch einen Kondensator aufweisen, dessen Kondensatorelektroden sich beim Auftreten einer Auslenkung z(t) entsprechend der Auslenkung aufeinander zu oder voneinander wegbewegen, so dass an den Kondensatorelektroden eine zeitlich veränderliche elektrische Spannung auftritt.

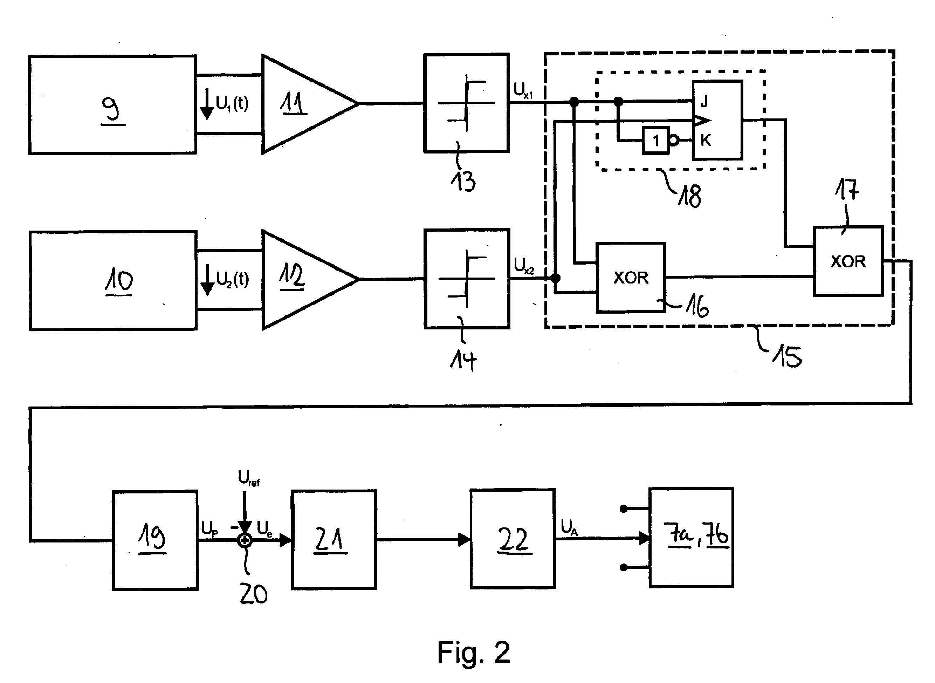

Wie in Fig. 2 erkennbar ist, ist zum Erzeugen eines Phasendifferenzsignals U_{P} für die Differenz zwischen der Phasenlage der Schwingung y(t) der Halterung und der Phasenlage der Schwingung z(t) der Auslenkstelle, eine Messeinrichtung vorgesehen, die in einen Phasenregelkreis geschaltet ist.

Die Messeinrichtung hat einen ersten Sensor 9 zur Erfassung eines von der mechanischen Anregungsschwingung y(t) abhängigen ersten Messsignals U₁(t) und einen zweiten Sensor 10 zur Erfassung einer von der Auslenkung z(t) des Biegekörpers 3 abhängigen zweiten Messsignals U₂(t), Bei dem in Fig. 2 gezeigten Ausführungsbeispiel sind die Sensoren 9, 10 jeweils als kapazitive Sensoren ausgestaltet, deren Messsignafe U₁(t), U₂(t) von der zeitlichen Ableitung der Auslenkung y(t) bzw. z(t) abhängig sind.

Die Sensoren 9, 10 haben jeweils differentielle Ausgänge, die über einen Verstärker 11, 12 mit einem Eingang eines Quantisierers 13, 14 verbunden sind. Mit Hilfe der Quantisierer 13, 14 werden die analogen Messsignale der Sensoren 9, 10 in entsprechende Binärsignale Uₓ₁, Uₓ₂ konvertiert (Sigma-Delta-Modulation).

Ein erster Ausgang eines dem ersten Sensor 9 zugeordneten ersten Quantisierers 13 ist mit einem ersten Eingang einer Phasenvergleichseinrichtung 15 und ein zweiter Ausgang eines dem zweiten Sensor 10 zugeordneten zweiten Quantisierers 14 ist mit einem zweiten Eingang der Phasenvergleichseinrichtung 15 verbunden. Die Phasenvergleichseinrichtung 15 hat zwei exclusiv-oder-Glieder 16, 17 und ein Korrekturglied 18 für die Quantisierung. Die Phasenvergleichseinrichtung 15 ist derart ausgestaltet, dass ein am Ausgang der Phasenvergleichseinrichtung 15 anliegendes Pulsweitenmodulationssignal Uₓ bei Übereinstimmung der Binärsignale Uₓ₁, Uₓ₂ einen ersten logischen Signalpegel und bei Nichtübereinstimmung der Binärsignale Uₓ₁, Uₓ₂ einen zweiten logischen Signalpegel aufweist.

Zur Mittelung der Quantisierung ist der Ausgang der Phasenvergleichseinrichtung 15 mit einem Eingang eines ersten Tiefpassfilters 19 verbunden. Ein Ausgang des ersten Tiefpassfilters 19 ist mit einem nichtinvertierenden Eingang eines Addierglieds 20 verbunden. Ein invertierender Eingang des Addierglieds 20 ist an einem in Fig. 2 nicht näher dargestellten Referenzsignalgeber angeschlossen, über den ein Sollwertsignal Uᵣₑₜ für den Phasenversatz zwischen der Phasenlage der Schwingung y(t) der Halterung und der Phasenlage der Schwingung z(t) der Auslenkstelle an den invertierenden Eingang des Addierglieds 20 anlegbar ist.

Das Addierglied 20 hat einen Ausgang für ein Regeldifferenzsignal Uₑ, der über einen Phasenregler 21 mit den Elektroden der Piezoelemente 7a, 7b verbunden ist. Der Phasenregler 21 weist bevorzugt ein PI-Glied auf, kann aber auch als P-Glied ausgestaltet sein. Das am invertierenden Eingang des Addierglieds 20 anliegende Sollwertsignal ist so gewählt, dass die Differenz zwischen der Phasenlage der Schwingung der Halterung y(t) und der Phasenlage der Schwingung z(t) des Resonanzelements auf-90° geregelt wird.

Bei Bedarf kann zwischen dem Ausgang des Phasenreglers 21 und den Elektroden der Piezoelemente 7a, 7b ein zweites Tiefpassfilter 22 angeordnet sein. Dadurch kann ein zu schnelles Ansteuern der Piezoelemente 7a, 7b unterdrückt und somit elektrische Energie eingespart werden.

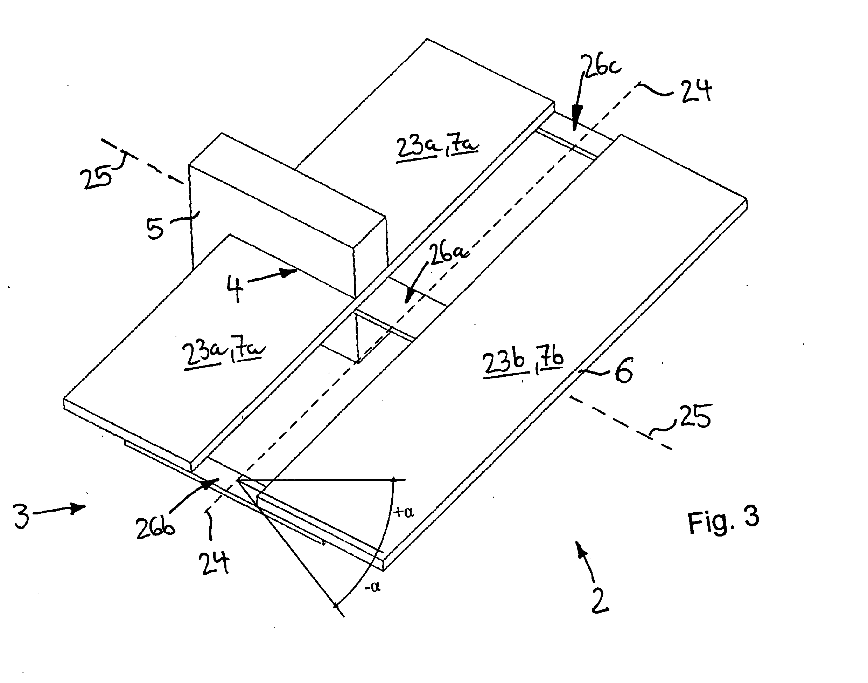

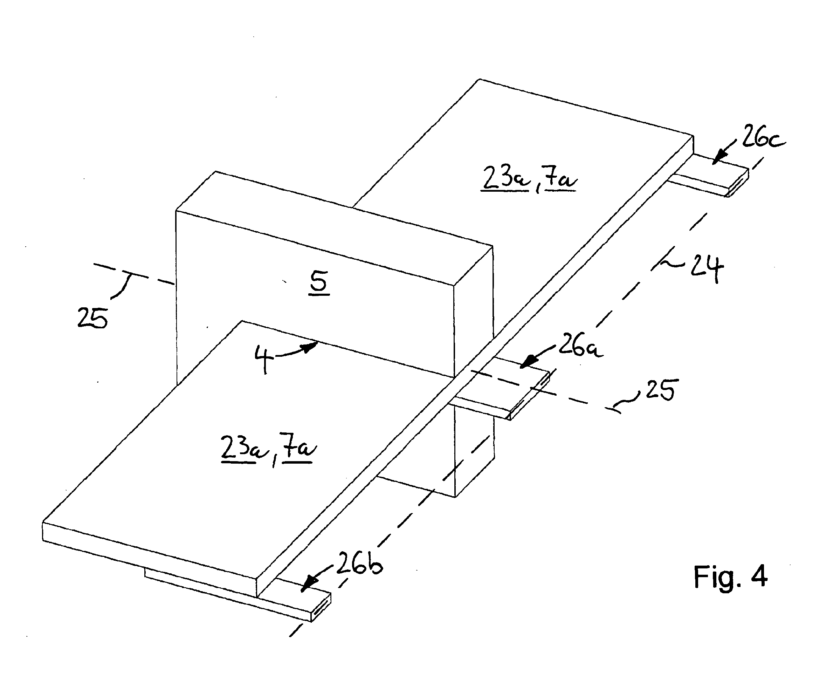

In Fig. 3 ist erkennbar, dass der Biegekörper 3 zwei flächige, etwa plattenförmige Biegekörperabschnitte 23a, 23b hat, die in Ruhelage in gerader Verlängerung nebeneinander angeordnet sind und an ihren einander zugewandten Rändern mittels einer Schwenklagerung um eine Schwenkachse 24 in beide Richtungen verschwenkbar miteinander verbunden sind. Der entsprechende Schwenkwinkel ist in Fig. 3 mit a bezeichnet. Wie sich aus Fig. 3 und 4 ergibt, ist die Schwenkachse etwa parallel zu einer von den plattenförmigen Elementen aufgespannten Ebene angeordnet.

Mit jedem Biegekörperabschnitt 23a, 23b ist jeweils eines der Piezoelemente 7a, 7b derart verbunden, dass sich die Biegekörperabschnitte 23a, 23b beim Anlegen der Spannung U_{A} an die Elektroden der Piezoelemente 7a, 7b jeweils um eine Biegeachse 25 elastisch verbiegen. Wie in Fig. 4 erkennbar ist, verläuft die Biegeachse 25 etwa orthogonal zur Schwenkachse 24. Beim Anlegen der Spannung U_{A} an die Elektroden der Piezoelemente 7a, 7b verbiegen sich die beiden Biegekörperabschnitte 23a, 23b in dieselbe Richtung. Es ist aber auch denkbar, dass die beiden Piezoelemente 7a, 7b unterschiedlich angeordnet sind, so dass sich die Biegekörperabschnitte 23a, 23b beim Anlegen der Spannung U_{A} in zueinander entgegen gesetzte Richtungen verbiegen.

Die Schwenklagerung weist drei auf der Schwenkachse 24 angeordnete Gelenke 26a, 26b, 26c auf, die in Richtung der Schwenkachse 24 voneinander beabstandet sind. Die Gelenke 26a, 26b, 26c sind jeweils als Festkörpergelenk ausgestaltet, das zwei um die Schwenkachse 24 relativ zueinander verschwenkbare Lagerteile aufweist, die einstückig miteinander verbunden sind. Ein erstes Lagerteil ist jeweils mit einem ersten Biegekörperabschnitt 23a und ein zweites Lagerteil mit einem zweiten Biegekörperabschnitt 23b verbunden, beispielsweise durch eine Schweiß- oder Lötstelle.

In Fig. 3 ist erkennbar, dass ein erstes Gelenk 26a etwa mittig zwischen einem zweiten Gelenk 26b und einem dritten Gelenk 26c angeordnet ist. Das zweite Gelenk 26b ist benachbart zu einem ersten Ende des Biegekörpers 3 und das dritte Gelenk 26c benachbart zu dem diesem Ende gegenüberliegenden zweiten Ende des Biegekörpers 3 angeordnet. Außerdem ist in Fig. 3 erkennbar, dass zwischen den Biegekörperabschnitten 23a, 23b ein Bewegungsfreiraum gebildet, durch den die Biegekörperabschnitte 23a, 23b quer zur Schwenkachse 24 voneinander beabstandet sind.

Die Befestigungsstelle 4 ist in Richtung der Schwenkachse 24 etwa mittig am ersten Biegekörperabschnitt 23a angeordnet. Der zweite Biegekörperabschnitt 23b ist nicht an der Halterung 5 eingespannt.

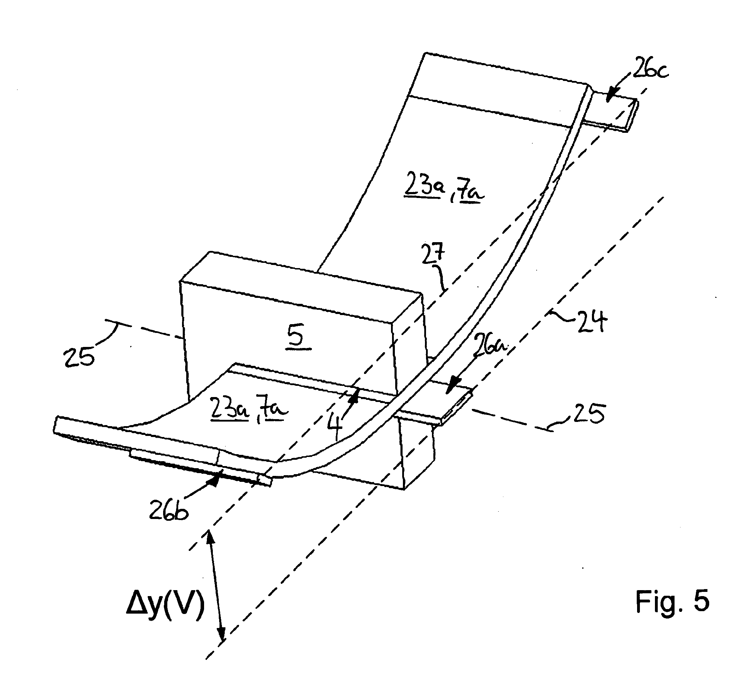

In Fig. 5 ist erkennbar, dass eine vom zweiten Gelenk 26b zum dritten Gelenk 26c verlaufende gerade Verbindungslinie 27 durch einen Abstand Δy von der Schwenkachse 24 des ersten Gelenks 26a beabstandet ist, wenn die Biegekörperabschnitte 23a, 23b derart biegeverformt sind, dass sie einen von einer Ebene abweichenden, gekrümmten Verlauf aufweisen. Dabei ist der Abstand Δy von der an den Elektroden der Piezoelemente 7a, 7b anliegenden Spannung U_{A} abhängig. Die Gelenkachsen der drei Gelenke 26a, 26b, 26c sind dann nicht in gerader Verlängerung zueinander angeordnet, so dass bei einer Relativverschwenkung der Biegekörperabschnitte 23a, 23b um die Schwenkachse 24 Zug- und/oder Druckkräfte zwischen den Lagerteilen der Gelenke 26a, 26b, 26c auftreten. Diese Kräfte werden von den Lagerteilen auf die Biegekörperabschnitte 23a, 23b übertragen und verformen diese elastisch. Dadurch vergrößert sich die Federkonstante k(U_{A}).

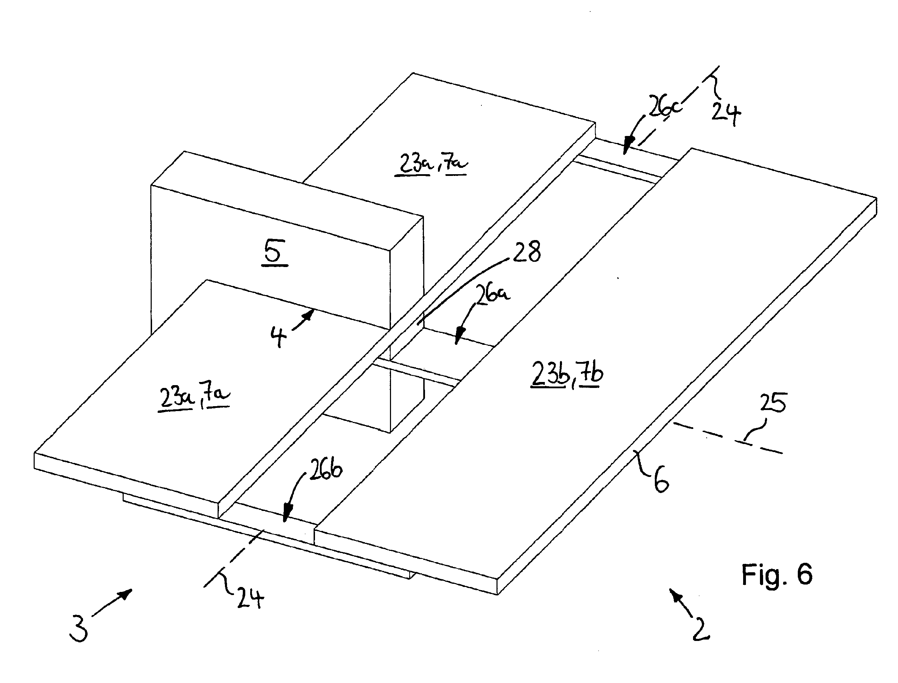

Bei dem in Fig. 6 gezeigten Ausführungsbeispiel ist zwischen den Lagerteilen des ersten Gelenks 26a und den Biegekörperabschnitten 23a, 23b jeweils ein Distanzstück 28 angeordnet. An den Lagerteilen des zweiten Gelenks 26b und des dritten Gelenk 26c sind dagegen keine Distanzstücke vorgesehen. Vielmehr sind diese Lagerteile direkt mit den Biegekörperabschnitten 23a, 23b verbunden. In einer Ruhelage, in der die Biegekörperabschnitte 23a, 23b in derselben Ebene bzw. in gerader Verlängerung zueinander angeordnet sind und in der die Piezoelemente 7a, 7b keine Biegekräfte in die Biegekörper einleiten, ist also die Gelenkachse des ersten Gelenks 26a von einer die Gelenkachse des zweiten Gelenks 26b mit der Gelenkachse des dritten Gelenks 26c verbindenden geraden Linie beabstandet.

Dadurch tritt bei einer Relativverschwenkung der Biegekörperabschnitte 23a, 23b um die Schwenkachse 24 zwischen den Biegekörperabschnitten 23a, 23b auch dann eine Rückstellkraft auf, wenn an den Elektroden der Piezoelemente 7a, 7b keine elektrische Spannung anliegt. Die Größe der Rückstellkraft ist davon abhängig, in welche Richtung die Biegekörperabschnitte 23a, 23b mit Hilfe der Piezoelemente 7a, 7b gekrümmt werden. Werden die Biegekörperabschnitte 23a, 23b mit ihren von der Halterung 5 entfernten Enden aus der in Fig. 6 dargestellten Ruhelage nach unten ausgelenkt, reduziert sich die Rückstellkraft bei konstantem Schwenkwinkel a. Werden die freien Enden Biegekörperabschnitte 23a, 23b aus der Ruhelage nach oben ausgelenkt, erhöht sich die Rückstellkraft bei konstantem Schwenkwinkel a.

## Patentansprüche

1. Vorrichtung (1) zum Erzeugen von elektrischer Energie aus einer mechanischen Anregungsschwingung, mit einem mechanischen Resonator (2), der mindestens ein Resonanzelement und eine Halterung (5) dafür aufweist, auf welche die Anregungsschwingungen übertragbar sind, wobei das Resonanzelement an einer Befestigungsstelle (4) mit der Halterung (5) verbunden ist und an einer von der Befestigungsstelle (4) beabstandeten Auslenkstelle (6) relativ zu der Befestigungsstelle (4) elastisch auslenkbar ist, mit einem Stellglied zum Einstellen der Resonanzfrequenz des Resonanzelements, wobei die Auslenkstelle (6) mit einem elektrischen Generator (8) in Antriebsverbindung steht, **dadurch gekennzeichnet, dass** die Vorrichtung (1) eine Messeinrichtung zum Erzeugen eines Phasendifferenzsignals (Up) für die Differenz zwischen der Phasenlage der Schwingung der Halterung (5) und der Phasenlage der Schwingung der Auslenkstelle (6) aufweist, und dass ein Ausgang der Messeinrichtung zum Anpassen der Resonanzfrequenz des Resonanzelements an die Frequenz der mechanischen Schwingung der Halterung (5) über einen Phasenregler (21) mit dem Stellglied verbunden ist.

2. Vorrichtung (1) nach Anspruch 1, **dadurch gekennzeichnet, dass** die Messeinrichtung einen ersten Sensor (9) zur Erfassung eines von der mechanischen Anregungsschwingung abhängigen ersten Messsignals und einen zweiten Sensor (10) zur Erfassung einer von der Auslenkung des Resonanzelements abhängigen zweiten Messsignals aufweist, und dass Messsignalausgänge der Sensoren (9, 10) über eine Phasenvergleichseinrichtung (15) mit dem Ausgang der Messeinrichtung verbunden sind.

3. Vorrichtung (1) nach Anspruch 1 oder 2, **dadurch gekennzeichnet, dass** der Phasenregler (21) derart ausgestaltet ist, dass die Differenz zwischen der Phasenlage der Schwingung der Halterung (5) und der Phasenlage der Schwingung des Resonanzelements auf-90° geregelt wird.

4. Vorrichtung (1) nach einem der Ansprüche 1 bis 3, **dadurch gekennzeichnet, dass** der erste Sensor (9) und/oder zweite Sensor (10) einen Beschleunigungssensor und/oder einen Geschwindigkeitssensor umfasst.

5. Vorrichtung (1) nach einem der Ansprüche 1 bis 4, **dadurch gekennzeichnet, dass** der zweite Sensor (10) ein Kraftsensor ist, der zur Messung einer Rückstellkraft des Resonanzelements angeordnet ist.

6. Vorrichtung (1) nach einem der Ansprüche 1 bis 5, **dadurch gekennzeichnet, dass** der Phasenregler (21) einen P-, PI-, PD- oder PID-Regler aufweist.

7. Vorrichtung (1) nach einem der Ansprüche 1 bis 6, **dadurch gekennzeichnet, dass** das Stellglied mindestens ein Piezoelement (7a, 7b) und eine elektrische Ansteuereinrichtung aufweist, die mit Elektroden des mindestens einen Piezoelements (7a, 7b) verbunden ist, dass das Resonanzelement als Biegekörper (3) ausgestaltet ist, und dass das mindestens eine Piezoelement (7a, 7b) derart mit dem Biegekörper (3) verbunden ist, dass es diesen bei Anlegen einer elektrischen Spannung an die Elektroden des Piezoelements (7a, 7b) versteift.

8. Vorrichtung (1) nach einem der Ansprüche 1 bis 7, **dadurch gekennzeichnet, dass** der zweite Sensor (10) oder der Generator (8) durch die Elektroden des mindestens einen Piezoelements (7a, 7b) und eine mit den Elektroden verbundene Hochpassschaltung gebildet ist.

9. Vorrichtung (1) nach einem der Ansprüche 1 bis 8, **dadurch gekennzeichnet, dass** der Biegekörper (3) als Federbalken ausgestaltet ist.

10. Vorrichtung (1) nach einem der Ansprüche 1 bis 9, **dadurch gekennzeichnet, dass** das Stellglied mindestens einen Aktor aufweist, der wenigstens zwei relativ zueinander verstellbare Aktorstellen hat, die derart mit dem Biegekörper (3) verbunden sind, dass dieser durch Betätigen des Aktors um eine Biegeachse (25) elastisch biegbar ist, dass der Biegekörper (3) mindestens zwei Biegekörperabschnitte (23a, 23b) hat, die mittels einer Schwenklagerung um eine zwischen der Befestigungsstelle (4) und der Auslenkstelle (6) angeordnete Schwenkachse (24) relativ zueinander verschwenkbar miteinander verbunden sind, und dass die Schwenkachse (24) derart quer zur Biegeachse (25) angeordnet ist, dass die Schwenklagerung durch Verschwenken der Biegekörperabschnitte (23a, 23b) relativ zueinander mit von der Biegeverformung abhängigen Zug- und/oder Druckkräften beaufschlagbar ist.

11. Vorrichtung (1) nach einem der Ansprüche 1 bis 10, **dadurch gekennzeichnet, dass** die Biegekörperabschnitte (23a, 23b) als flächige, vorzugsweise plattenförmige Elemente ausgestaltet sind, und dass die Schwenkachse (24) im Wesentlichen in einer von mindestens einem der plattenförmigen Elementen aufgespannten Ebene oder parallel dazu angeordnet ist.

12. Vorrichtung (1) nach einem der Ansprüche 1 bis 11, **dadurch gekennzeichnet, dass** die Schwenklagerung als Festkörpergelenk ausgestaltet ist, das mindestens zwei um die Schwenkachse (24) relativ zueinander verschwenkbare Lagerteile aufweist, die einstückig miteinander verbunden sind.

13. Vorrichtung (1) nach einem der Ansprüche 1 bis 12, **dadurch gekennzeichnet, dass** die Schwenklagerung mindestens drei auf der Schwenkachse (24) oder benachbart dazu angeordnete Gelenke (26a, 26b, 26c) aufweist, die in Richtung der Schwenkachse (24) voneinander beabstandet sind.

14. Vorrichtung (1) nach einem der Ansprüche 1 bis 1 3, **dadurch gekennzeichnet, dass** ein erstes Gelenk (26a) etwa mittig zwischen einem zweiten Gelenk (26b) und einem dritten Gelenk (26c) angeordnet ist, und dass die Befestigungsstelle (4) vorzugsweise in Höhe des ersten Gelenks (26a) angeordnet ist.

15. Vorrichtung (1) nach einem der Ansprüche 1 bis 14, **dadurch gekennzeichnet, dass** die einzelnen Gelenke (26a, 26b, 26c) jeweils zwei um eine Gelenkstelle relativ zueinander verschwenkbare Gelenkteile aufweisen, von denen ein erstes Gelenkteil mit einem ersten Biegekörperabschnitt (23a) und ein zweites Gelenkteil mit einem zweiten Biegekörperabschnitt (23b) verbunden ist, und dass in einer Ruhelage, in welcher das Stellglied keine Biegekraft in den Biegekörper (3) einleitet, die Gelenkstelle eines ersten Gelenks (26a, 26b) von einer die Gelenkstelle eines zweiten Gelenks (26b) mit der Gelenkstelle eines dritten Gelenks (26c) verbindenden geraden Linie beabstandet ist.

16. Verfahren zum Erzeugen von elektrischer Energie aus einer mechanischen Anregungsschwingung, wobei ein mechanischer Resonator bereitgestellt wird, der mindestens ein an einer Halterung (5) angeordnetes Resonanzelement aufweist, das an einer Befestigungsstelle (4) mit der Halterung (5) verbunden ist und an einer von der Befestigungsstelle (4) beabstandeten Auslenkstelle (6) relativ zu der Befestigungsstelle elastisch auslenkbar ist, wobei die Halterung (5) derart der Anregungsschwingung ausgesetzt wird, dass die Auslenkstelle (6) relativ zu der Befestigungsstelle (4) in Schwingungen versetzt wird, **dadurch gekennzeichnet, dass** ein Phasendifferenzsignal (Dₚ) für die Differenz zwischen der Phasenlage der Anregungsschwingung und der Phasenlage der Schwingung der Auslenkstelle (6) erzeugt wird, dass das Phasendifferenzsignal (Uₚ) mit einem Sollwertsignal (U_{ref}) verglichen wird, und dass beim Auftreten einer Abweichung zwischen dem Phasendifferenzsignal (Up) und dem Sollwertsignal (U_{ref}) die Resonanzfrequenz des Resonanzelements im Sinne einer Reduzierung der Abweichung verstellt wird.

17. Verfahren nach Anspruch 16, **dadurch gekennzeichnet, dass** die Resonanzfrequenz des Resonanzelements durch Ändern der mechanischen Steifigkeit des Resonanzelements verstellt wird.

## Claims

1. Device (1) for generating electric energy from a mechanical excitation oscillation, comprising a mechanical resonator (2), which has at least one resonant element and a support (5) therefor to which the excitation oscillations can be transmitted, wherein the resonant element is connected to the support (5) at a fastening point (4) and can be elastically deflected in relation to the fastening point (4) at a deflection point (6) that is kept at a distance from the fastening point (4), comprising an actuating element for setting the resonant frequency of the resonant element, wherein the deflection point (6) is in driving connection with an electric generator (8), **characterized in that** the device (1) has a measuring device for producing a phase differential signal (Up) for the difference between the phase position of the oscillation of the support (5) and the phase position of the oscillation of the deflection point (6), and **in that** an output of the measuring device is connected to the actuating element via a phase controller (21) in order to adapt the resonant frequency of the resonant element to the frequency of the mechanical oscillation of the support (5).

2. Device (1) according to Claim 1, **characterized in that** the measuring device has a first sensor (9) for sensing a first measuring signal, which is dependent on the mechanical excitation oscillation, and a second sensor (10) for sensing a second measuring signal, which is dependent on the deflection of the resonant element, and **in that** measuring signal outputs of the sensors (9, 10) are connected to the output of the measuring device via a phase comparing device (15).

3. Device (1) according to Claim 1 or 2, **characterized in that** the phase controller (21) is designed in such a way that the difference between the phase position of the oscillation of the support (5) and the phase position of the oscillation of the resonant element is controlled to -90°.

4. Device (1) according to one of Claims 1 to 3, **characterized in that** the first sensor (9) and/or the second sensor (10) comprises an acceleration sensor and/or a speed sensor.

5. Device (1) according to one of Claims 1 to 4, **characterized in that** the second sensor (10) is a force sensor, which is arranged for measuring a restoring force of the resonant element.

6. Device (1) according to one of Claims 1 to 5, **characterized in that** the phase controller (21) has a P, PI, PD or PID controller.

7. Device (1) according to one of Claims 1 to 6, **characterized in that** the actuating element has at least one piezo element (7a, 7b) and an electrical activating device, which is connected to electrodes of the at least one piezo element (7a, 7b), **in that** the resonant element is designed as a bending body (3), and **in that** the at least one piezo element (7a, 7b) is connected to the bending body (3) in such a way that it stiffens when an electric voltage is applied to the electrodes of the piezo element (7a, 7b).

8. Device (1) according to one of Claims 1 to 7, **characterized in that** the second sensor (10) or the generator (8) is formed by the electrodes of the at least one piezo element (7a, 7b) and a high-pass circuit connected to the electrodes.

9. Device (1) according to one of Claims 1 to 8, **characterized in that** the bending body (3) is designed as a spring beam.

10. Device (1) according to one of Claims 1 to 9, **characterized in that** the actuating element has at least one actuator, which has at least two actuating points, which are adjustable in relation to one another and are connected to the bending body (3) in such a way that it can be elastically bent about a bending axis (25) by actuating the actuator, **in that** the bending body (3) has at least two bending body portions (23a, 23b), which are connected to one another pivotably in relation to one another by means of a pivot mounting about a pivot axis (24) arranged between the fastening point (4) and the deflection point (6), and **in that** the pivot axis (24) is arranged transversely in relation to the bending axis (25) in such a way that, by pivoting the bending body portions (23a, 23b) in relation to one another, the pivot mounting can be subjected to tensile and/or compressive forces that are dependent on the bending deformation.

11. Device (1) according to one of Claims 1 to 10, **characterized in that** the bending body portions (23a, 23b) are designed as two-dimensional, preferably plate-like elements, and **in that** the pivot axis (24) is arranged substantially in a plane defined by at least one of the plate-like elements or parallel thereto.

12. Device (1) according to one of Claims 1 to 11, **characterized in that** the pivot mounting is designed as a flexure, which has at least two bearing parts, which are pivotable in relation to one another about the pivot axis (24) and are connected to one another in one piece.

13. Device (1) according to one of Claims 1 to 12, **characterized in that** the pivot mounting has at least three joints (26a, 26b, 26c), which are arranged on the pivot axis (24) or adjacent thereto and are kept at a distance from one another in the direction of the pivot axis (24).

14. Device (1) according to one of Claims 1 to 13, **characterized in that** a first joint (26a) is arranged approximately centrally between a second joint (26b) and a third joint (26c), and **in that** the fastening point (4) is preferably arranged level with the first joint (26a).

15. Device (1) according to one of Claims 1 to 14, **characterized in that** the individual joints (26a, 26b, 26c) respectively have two joint parts, which can be pivoted in relation to one another about a point of articulation, of which a first joint part is connected to a first bending body portion (23a) and a second joint part is connected to a second bending body portion (23b), and **in that**, in a position of rest in which the actuating element does not introduce any bending force into the bending body (3), the point of articulation of a first joint (26a, 26b) is at a distance from a straight line joining the point of articulation of a second joint (26b) to the point of articulation of a third joint (26c).

16. Method for generating electric energy from a mechanical excitation oscillation, wherein a mechanical resonator is provided, having at least one resonant element, which is arranged on a support (5), is connected to the support (5) at a fastening point (4) and can be elastically deflected in relation to the fastening point (4) at a deflection point (6) that is kept at a distance from the fastening point (4), wherein the support (5) is exposed to the excitation oscillation in such a way that the deflection point (6) is made to oscillate in relation to the fastening point (4), **characterized in that** a phase differential signal (Up) for the difference between the phase position of the excitation oscillation and the phase position of the oscillation of the deflection point (6) is produced, **in that** the phase differential signal (Up) is compared with a setpoint signal (U_{ref}), and **in that**, if there is a deviation between the phase differential signal (Up) and the setpoint signal (U_{ref}), the resonant frequency of the resonant element is adjusted in the sense of a reduction of the deviation.

17. Method according to Claim 16, **characterized in that** the resonant frequency of the resonant element is adjusted by changing the mechanical stiffness of the resonant element.

## Revendications

1. Dispositif (1) de production d'énergie électrique à partir d'une vibration d'excitation mécanique, le dispositif présentant
un résonateur mécanique (2) qui présente au moins un élément de résonance et un support (5) sur lequel les vibrations d'excitation peuvent être transférées,
l'élément de résonance étant raccordé au support (5) en un emplacement de fixation (4) et pouvant être dévié élastiquement par rapport à l'emplacement de fixation (4) en un emplacement de déviation (6) situé à distance de l'emplacement de fixation (4),
et un organe de réglage qui établit la fréquence de résonance de l'élément de résonance,
l'emplacement de déviation (6) étant raccordé à entraînement à un générateur électrique (8), **caractérisé en ce que**
le dispositif (1) présente un dispositif de mesure qui forme un signal (Up) de déphasage de la différence entre la phase de l'oscillation du support (5) et la phase de l'oscillation de l'emplacement de déviation (6) et
**en ce qu'**une sortie du dispositif de mesure est raccordée par l'intermédiaire d'un régulateur de phase (21) à l'organe de réglage pour adapter la fréquence de résonance de l'élément de résonance à la fréquence de l'oscillation mécanique du support (5).

2. Dispositif (1) selon la revendication 1, **caractérisé en ce que** le dispositif de mesure présente un premier capteur (9) qui saisit un premier signal de mesure qui dépend de l'oscillation mécanique d'excitation et un deuxième capteur (10) qui saisit un deuxième signal de mesure qui dépend de la déviation de l'élément de résonance et **en ce que** les sorties des signaux de mesure et des capteurs (9, 10) sont raccordées à la sortie du dispositif de mesure par l'intermédiaire d'un dispositif (15) de comparaison de phase.

3. Dispositif (1) selon les revendications 1 ou 2, **caractérisé en ce que** le régulateur de phase (21) est configuré de telle sorte que la différence entre la phase de l'oscillation du support (5) et la phase de l'oscillation de l'élément de résonance soit réglée à -90°.

4. Dispositif (1) selon l'une des revendications 1 à 3, **caractérisé en ce que** le premier capteur (9) et/ou le deuxième capteur (10) comportent un capteur d'accélération et/ou un capteur de vitesse.

5. Dispositif (1) selon l'une des revendications 1 à 4, **caractérisé en ce que** le deuxième capteur (10) est un capteur de force disposé de manière à mesurer la force de rappel de l'élément de résonance.

6. Dispositif (1) selon l'une des revendications 1 à 5, **caractérisé en ce que** le régulateur de phase (21) présente un régulateur P, PI, PD ou PID.

7. Dispositif (1) selon l'une des revendications 1 à 6, **caractérisé en ce que** l'organe de réglage présente au moins un élément piézoélectrique (7a, 7b) et un dispositif électrique de commande qui est raccordé aux électrodes du ou des éléments piézoélectriques (7a, 7b), **en ce que** l'élément de résonance est configuré comme corps flexible (3) et **en ce que** le ou les éléments piézoélectriques (7a, 7b) sont raccordés au corps flexible (3) de telle sorte que les éléments piézoélectriques rigidifient le corps flexible lorsqu'une tension électrique est appliquée sur les électrodes des éléments piézoélectriques (7a, 7b).

8. Dispositif (1) selon l'une des revendications 1 à 7, **caractérisé en ce que** le deuxième capteur (10) ou le générateur (8) sont formés par les électrodes du ou des éléments piézoélectriques (7a, 7b) et par un circuit passe-haut raccordé aux électrodes.

9. Dispositif (1) selon l'une des revendications 1 à 8, **caractérisé en ce que** le corps flexible (3) est configuré comme barre de ressort.

10. Dispositif (1) selon l'une des revendications 1 à 9, **caractérisé en ce que** l'organe de réglage présente au moins un actionneur qui possède au moins deux emplacements d'actionnement qui peuvent être déplacés l'un par rapport à l'autre et qui sont raccordés au corps flexible (3) de telle sorte que par actionnement de l'actionneur, ce dernier puisse être fléchi élastiquement autour d'un axe de flexion (25), **en ce que** le corps flexible (3) présente au moins deux parties (23a, 23b) de corps flexible qui sont raccordées l'une à l'autre de manière pivotante l'une par rapport à l'autre au moyen d'un palier pivotant autour d'un axe de pivotement (24) disposé entre l'emplacement de fixation (4) et l'emplacement de déviation (6) et **en ce que** l'axe de pivotement (24) est disposé transversalement par rapport à l'axe de flexion (25) de telle sorte que des forces de traction et/ou de poussée dépendant de la déformation de flexion puissent être appliquées sur le palier pivotant par pivotement des parties (23a, 23b) du corps fléchissant l'une par rapport à l'autre.

11. Dispositif (1) selon l'une des revendications 1 à 10, **caractérisé en ce que** les parties (23a, 23b) du corps flexible sont configurées comme éléments plats de préférence en forme de plaques et **en ce que** l'axe de pivotement (24) est disposé essentiellement dans un plan sous-tendu par au moins l'un des éléments en forme de plaque ou parallèle à ce dernier.

12. Dispositif (1) selon l'une des revendications 1 à 11, **caractérisé en ce que** le palier pivotant est configuré comme articulation solide qui présente au moins deux parties de palier aptes à pivoter l'une par rapport à l'autre autour de l'axe de pivotement (24) et raccordées d'un seul tenant l'une à l'autre.

13. Dispositif (1) selon l'une des revendications 1 à 12, **caractérisé en ce que** le palier de pivotement présente au moins trois articulations (26a, 26b, 26c) disposées sur l'axe de pivotement (24) ou à proximité de ce dernier et maintenues à distance l'une de l'autre dans la direction de l'axe de pivotement (24).

14. Dispositif (1) selon l'une des revendications 1 à 13, **caractérisé en ce qu'**une première articulation (26a) est disposée sensiblement au milieu entre une deuxième articulation (26b) et une troisième articulation (26c) et **en ce que** l'emplacement de fixation (4) est disposé de préférence à hauteur de la première articulation (26a).

15. Dispositif (1) selon l'une des revendications 1 à 14, **caractérisé en ce que** les différentes articulations (26a, 26b, 26c) présentent toutes deux parties d'articulation aptes à pivoter l'une par rapport à l'autre autour d'un emplacement d'articulation, une première partie d'articulation étant raccordée à une première partie (23a) du corps flexible et une deuxième partie d'articulation à une deuxième partie (23b) du corps flexible et **en ce que** dans une position de repos dans laquelle l'organe de réglage n'exerce pas de force de flexion sur le corps flexible (3), l'emplacement d'articulation d'une première articulation (26a, 26b) est maintenu à distance d'une ligne droite qui relie l'emplacement d'articulation d'une deuxième articulation (26b) à l'emplacement d'articulation d'une troisième articulation (26c).

16. Procédé de production d'énergie électrique à partir d'une vibration d'excitation mécanique, dans lequel un résonateur mécanique qui présente au moins un élément de résonance disposé sur un support (5) et raccordé au support (5) en un emplacement de fixation (4) et apte à être dévié élastiquement par rapport à l'emplacement de fixation en un emplacement de déviation (6) maintenu à distance de l'emplacement de fixation (4) est prévu,
le support (5) étant exposé à l'oscillation d'excitation de telle sorte que l'emplacement de déviation (6) soit déplacé en oscillation par rapport à l'emplacement de fixation (4),
**caractérisé en ce que**
un signal (Up) de déphasage de la différence entre la phase de l'oscillation d'excitation et la phase de l'oscillation de l'emplacement de déviation (6) est formé,
**en ce que** le signal (Up) de déphasage est comparé à un signal (U_{ref}) de valeur de consigne et
**en ce qu'**en cas d'apparition d'un écart entre le signal (Up) de déphasage et le signal (U_{ref}) de valeur de consigne, la fréquence de résonance de l'élément de résonance est ajustée dans le sens d'une réduction de l'écart.

17. Procédé selon la revendication 16, **caractérisé en ce que** la fréquence de résonance de l'élément de résonance est ajustée par modification de la rigidité mécanique de l'élément de résonance.
